# FASCICULE DE BREVET EUROPEEN

(11) **EP 0 446 104 B1**
(45) Date de publication et mention de la délivrance du brevet: **13.04.1994**
(21) Numéro de dépôt: 91400545.9
(22) Date de dépôt: 28.02.1991
(51) Int. Cl.: H05K 7/20

(54) **Dispositif de montage pour boîtiers électroniques de puissance dans une enveloppe**
Vorrichtung zur Befestigung von elektronischen Leistungsgehäusen in einer Unterbringung
Device for mounting electronic power casings in housing

(30) Priorité: 08.03.1990 FR 9002924
(43) Date de publication de la demande: 11.09.1991
(73) Titulaire: TELEMECANIQUE, 92504 Rueil Malmaison Cedex (FR)
(72) Inventeur: Brisac, Claude, F-95330 Domont (FR); Dore, Christophe, F-78450 Villepreux (FR); Pichereau, Rodolphe, F-78400 Chatou (FR)
(74) Mandataire: de Saint-Palais, Arnaud Marie

(56) Documents cités:
- FR-A- 2 011 668
- FR-A- 2 392 498
- US-A- 3 462 553

## Description

La présente invention concerne un dispositif de montage et de refroidissement pour boîtiers électroniques de puissance dans une enveloppe logeant un agencement électronique.

Dans de tels dispositifs, les boîtiers électroniques de puissance - par exemple à semi-conducteurs - dissipent de la chaleur et sont donc fixés en bon contact thermique sur des dissipateurs. Ceux-ci sont généralement réalisés à partir d'un corps extrudé en alliage léger et comportent une semelle définissant un plan de support et de fixation pour les boîtiers de puissance, ainsi que des ailettes de dissipation thermique orientées de façon sensiblement perpendiculaire au plan de fixation.

Au dispositif est souvent adjoint un système de ventilation qui accélère l'évacuation de la chaleur provenant des boîtiers et transmise à la semelle et aux ailettes.

Dans un dispositif connu du type décrit, le dissipateur thermique est fixé à des parois latérales de l'enveloppe qui sont perpendiculaires au plan de fixation des boîtiers et cela, au moyen de vis d'axes parallèles à ce plan. Les vis sont engagées, soit dans des écrous installés dans des glissières de la semelle, soit dans des orifices taraudés de la semelle, ce qui impose une surépaisseur notable de celle-ci et entraîne donc un surcroît de matière et d'encombrement pour le dissipateur. La pose des boîtiers sur le plan de fixation de la semelle suppose, d'autre part, une reprise en perçage et taraudage de la semelle. Il résulte de tout ceci que les opérations d'usinage et de montage nécessaires pour fabriquer le dispositif connu sont malaisées et coûteuses.

L'invention a en particulier pour but de simplifier le processus de fabrication d'un dispositif de montage et de refroidissement pour boîtiers électroniques de puissance dans une enveloppe.

Elle a pour autre but de réduire la hauteur d'un tel dispositif.

Selon l'invention, dans un dispositif du type décrit :
- plusieurs passages traversants sont ménagés dans la semelle du dissipateur,
- des plots sont solidaires du fond de l'enveloppe, ces plots étant munis de trous taraudés coaxiaux aux passages prévus dans le dissipateur,
- des boulons de serrage des boîtiers sur le dissipateur sont engagés librement dans les passages du dissipateur et sont vissés dans les trous taraudés des plots pour fixer simultanément les boîtiers au dissipateur et le dissipateur au fond de l'enveloppe.

Il en résulte, d'une part, que la semelle du dissipateur peut être de hauteur réduite, car elle n'a plus à loger de vis parallèles au plan de fixation des boîtiers, d'autre part, que la réalisation du dispositif est facilitée.

La présente invention est définie dans la Revendication 1. Un dispositif conformément au préambule de la Revendication 1 est connu du document US-A-3 462 553.

Les passages prévus dans la semelle du dissipateur sont, de préférence, prévus en regard d'ailettes de positionnement de largeur supérieure à celle des ailettes de dissipation voisines et comprennent une partie traversante percée dans ces ailettes et servant notamment à positionner le dissipateur par rapport aux plots. Il est avantageux que les plots coopèrent par emboîtement avec les ailettes de positionnement, en particulier lorsque les plots sont cylindriques et logés dans des échancrures à surface cylindrique ouverte latéralement des nervures de positionnement.

D'autres caractéristiques et avantages de l'invention ressortiront à la lecture d'un exemple de réalisation donné à titre non limitatif, en regard des dessins annexés.
La figure 1 montre schématiquement en coupe partielle, un dispositif conforme à l'invention ;
La figure 2 représente, à plus grande échelle, une vue en coupe partielle du dissipateur ;
La figure 3 est une coupe partielle du dispositif selon le plan III-III indiqué figure 4 ;
Les figures 4 et 5 sont des vues partielles en coupe selon les plans IV-IV et V-V de la figure 3.

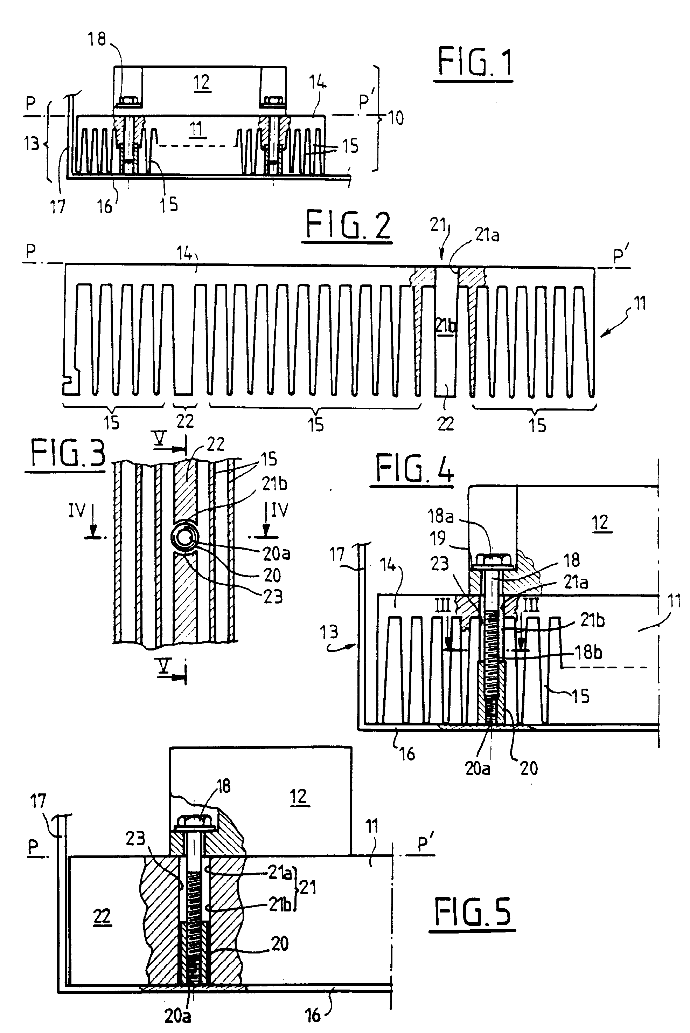

Le dispositif 10 de montage et de refroidissement pour boîtiers de puissance illustré sur la figure 1 comprend un dissipateur thermique 11 auquel sont fixés des boîtiers électroniques de puissance 12 et qui est lui-même fixé à une enveloppe 13 telle qu'un coffret ou un corps d'appareil électrique.

Le dissipateur thermique 11 est un corps extrudé en alliage d'aluminium. Il comporte une semelle 14 d'épaisseur réduite et des ailettes 15 orientées de manière sensiblement perpendiculaire à la semelle et déterminant un espace qui est ventilé par des moyens non représentés. La semelle 14 définit un plan P-P′ de pose et de fixation pour les boîtiers 12, ceux-ci étant, par exemple, constitués par des modules semi-conducteurs de puissance.

L'enveloppe 13 est en tôle d'acier ; elle comporte un fond 16 et des parois latérales 17 et loge un agencement électronique dont font partie les boîtiers de puissance 12.

La fixation de chaque boîtier sur le dissipateur s'effectue au moyen de boulons 18 (voir figures 4 et 5) dont les têtes 18a reposent sur un épaulement 19 du boîtier et dont les tiges filetées 18b coopèrent avec des plots taraudés 20 solidaires du fond 16 de l'enveloppe 13. Les plots 20 sont présentement des colonnettes cylindriques munies de trous taraudés 20a et soudées au fond 16 de l'enveloppe. Les plots peuvent être fixés de toute autre façon au fond 16 ; ils peuvent également comporter un système d'écrou prisonnier associé au fond 16. On constate que le dissipateur est en appui sur le fond 16 de l'enveloppe et que le serrage des boulons assure à la fois la fixation des boîtiers au dissipateur et la fixation de celui-ci sur l'enveloppe.

Les boulons 18 traversent des orifices prévus dans les boîtiers et des passages traversants 21 percés dans le dissipateur. Les figures 4 et 5 montrent, en coupe partielle, les zones des plots 20 et des passages 21. Ces passages comprennent une partie 21a percée dans la semelle 14 et prolongée par une partie 21b percée dans des ailettes de positionnement 22. Ces dernières sont plus larges et donc plus massives que les ailettes de dissipation voisines 15 pour éviter d'être endommagées au perçage. Le diamètre des passages 21 est préférentiellement supérieur à la largeur des ailettes de positionnement, de manière à créer, dans celles-ci des échancrures 23 à surfaces cylindriques, ouvertes latéralement, assurant par emboîtement des colonnettes dans ces échancrures un positionnement du dissipateur par rapport à l'enveloppe (voir figures 3 à 5).

Dans une variante moins satisfaisante du point de vue thermique et mécanique, les colonnettes taraudées 20 peuvent s'élever du fond 16 de l'enveloppe 13 jusqu'au voisinage de la semelle 14, l'ailette 22 étant alors supprimée. Les ailettes de positionnement 22 peuvent, d'autre part, présenter une hauteur plus faible que les ailettes de dissipation 15. Elles sont dans tous les cas en nombre très inférieur à celui des ailettes 15.

Il va de soi que les plots 20 et les passages 21 peuvent être disposés à intervalles réguliers ou non correspondant à divers types de modules semi-conducteurs de puissance susceptibles d'être rapportés.

## Revendications

1. Dispositif (10) de montage et de refroidissement pour boîtiers électroniques de puissance (12) dans une enveloppe (13) qui loge un agencement électronique, le dispositif comprenant un dissipateur thermique (11) qui est fixé à l'enveloppe et comporte, d'une part, une semelle (14) définissant un plan de fixation pour les boîtiers et, d'autre part, des ailettes (15) orientées perpendiculairement au plan de fixation, les boîtiers de puissance étant fixés au dissipateur à l'aide de boulons (18), plusieurs passages traversants (21) étant ménagés dans la semelle (14) du dissipateur (11),
caractérisé par le fait que :
- des plots (20) solidaires du fond (16) de l'enveloppe (13) sont munis de trous taraudés (20a) coaxiaux aux passages (21),
- les boulons (18) de serrage des boîtiers sur le dissipateur sont engagés librement dans les passages du dissipateur et sont vissés dans les trous taraudés des plots pour fixer simultanément les boîtiers au dissipateur et celui-ci au fond de l'enveloppe.

2. Dispositif selon la revendication 1,
caractérisé par le fait que le dissipateur (11) comprend des ailettes de positionnement (22) plus larges que les ailettes de dissipation voisines (15) et que les passages (21) comportent une partie traversante (21b) percée dans les ailettes de positionnement.

3. Dispositif selon la revendication 2,
caractérisé par le fait que le dissipateur est extrudé en alliage léger et que les plots (20) coopèrent par emboîtement avec les ailettes de positionnement (22).

4. Dispositif selon la revendication 3,
caractérisé par le fait que les plots (20) sont cylindriques et sont emboîtés dans des échancrures (23) à surfaces cylindriques créées dans les ailettes de positionnement (22) par le perçage des parties (21b) des passages (21) dans lesdites nervures.

## Patentansprüche

1. Vorrichtung (10) zum Einbau und zur Kühlung für elektronische Leistungsgehäuse (12) in einer Hülle (13), die eine elektronische Anordnung aufnimmt, wobei die Vorrichtung einen Wärmeableiter (11) enthält, der an der Hülle befestigt ist und einerseits eine Platte (14), die eine Befestigungsebene für die Gehäuse definiert, und andererseits Rippen (15) aufweist, die senkrecht zur Befestigungsebene ausgerichtet sind, wobei die Leistungsgehäuse mit Hilfe von Bolzen (18) am Ableiter befestigt sind, wobei mehrere Durchlässe (21) in der Platte (14) des Ableiters (11) angebracht sind,
dadurch gekennzeichnet, daß:
- fest mit dem Boden (16) der Hülle (13) verbundene Klötze (20) mit zu den Durchlässen (21) koaxialen Gewindelöchern (20a) versehen sind,
- die Bolzen (18) zum Festklemmen der Gehäuse auf dem Ableiter frei in die Durchlässe des Ableiters eingeführt und in die Gewindelöcher der Klötze eingeschraubt sind, um gleichzeitig die Gehäuse am Ableiter und diesen am Boden der Hülle zu befestigen.

2. Vorrichtung nach Anspruch 1, dadurch gekennzeichnet, daß der Ableiter (11) Positionierrippen (22) aufweist, die breiter sind als die benachbarten Wärmeableitungsrippen (15), und daß die Durchlässe (21) einen durchquerenden Teil (21b) aufweisen, der in die Positionierrippen gebohrt ist.

3. Vorrichtung nach Anspruch 2, dadurch gekennzeichnet, daß der Ableiter aus Leichtmetall-Legierung extrudiert wird und daß die Klötze (20) durch Einfügung mit den Positionierrippen (22) zusammenwirken.

4. Vorrichtung nach Anspruch 3, dadurch gekennzeichnet, daß die Klötze (20) zylindrisch geformt und in Ausschnitte (23) mit zylindrischen Oberflächen eingefügt sind, die in den Positionierrippen (22) durch die Bohrung der Teile (21b) der Durchlässe (21) in diesen Rippen erzeugt werden.

## Claims

1. Mounting and cooling device (10) for power electronics cases (12) in an envelope (13) which houses an electronics arrangement, the device comprising a heat dissipator (11) which is secured to the envelope and comprises, on the one hand, a sole plate (14) defining a mounting plane for the cases, and, on the other hand, fins (15) oriented perpendicularly to the mounting plane, the power cases being secured to the dissipator by means of bolts (18), plural through passages (21) being provided in the sole plate (14) of the dissipator (11),
characterized by the fact that:
- pins (20) interdependent with the base (16) of the envelope (13) are fitted with threaded holes (20a) coaxial with the passages (21),
- the bolts (18) for tightening the cases to the dissipator are freely engaged in the passages of the dissipator and are screwed into the threaded holes of the pins to simultaneously secure the cases to the dissipator and the latter to the base of the envelope.

2. Device according to claim 1,
characterized by the fact that the dissipator (11) comprises positioning fins (22) larger than the neighbouring dissipation fins (15) and that the passages (21) comprise a through part (21b) bored in the positioning fins.

3. Device according to claim 2,
characterized by the fact that the dissipator is extruded in light alloy and that the pins (20) cooperate by nesting with the positioning fins (22).

4. Device according to claim 3,
characterized by the fact that the pins (20) are cylindrical and are nested into scallopings (23) of cylindrical surface created in the positioning fins (22) by the boring of the parts (21b) of the passages (21) in said ribs.
